# EUROPEAN PATENT APPLICATION

(11) **EP 2 081 234 A2**
(43) Date of publication of application: **22.07.2009**
(21) Application number: 09150058.7
(22) Date of filing: 05.01.2009
(51) Int. Cl.: H01L 31/0224, H01L 31/0392

(54) **Thin-film type solar cell and manufacturing method thereof**

(30) Priority: 09.01.2008 KR 20080002695
(71) Applicant: LG Electronics Inc., Seoul, 150-721 (KR)
(72) Inventor: Eo, Young-Joo, 137-724, SEOUL (KR); Kim, Bum-Sung, 137-724, SEOUL (KR); Lee, Heon-Min, 137-724, SEOUL (KR); Lee, Hae-Seok, 137-724, SEOUL (KR); Ahn, Seh-Won, 137-724, SEOUL (KR)
(74) Representative: Cabinet Plasseraud

(57) **Abstract**

The present invention discloses a thin-film type solar cell including another upper transparent conductive layer between a silicon semiconductor layer and an upper transparent conductive layer, and a manufacturing method thereof. At this time, the silicon based semiconductor layer used may be formed of at least one amorphous silicon based (p/i/n) thin film or may be formed as a tandem type silicon based semiconductor layer formed of the amorphous silicon based (p/i/n) thin film, an intermediate transparent conductive layer, and a microcrystalline silicon based thin film.

## Description

### [BACKGROUND OF THE INVENTION]

This application claims priority to Korean Patent Application No. 10-2008-0002695, filed on January 9, 2008 in the Korean Intellectual Property Office, the entire contents of which are hereby incorporated by reference.

### [Technical Field]

The present invention relates to a thin-film type solar cell which improves efficiency of a solar cell by stacking another upper transparent conductive layer between a silicon semiconductor layer formed of an amorphous silicon based (p/i/n) thin film or a tandem type silicon based thin film and an upper transparent conductive layer, and a manufacturing method thereof.

### [Background Art]

Over the past few years, several studies for a solar cell as next-generation clean energy source have been developed. A solar cell using single crystal bulk silicon currently commercialized has not been actively utilized due to a high manufacturing cost and an installation cost thereof. In order to solve such problems related to the cost, a study for a thin-film type solar cell has been actively developed. In particular, a thin-film type solar cell using amorphous silicon (a-Si:H), which can be used to manufacture a large-area solar cell module with a low cost, has attracted a great deal of interest.

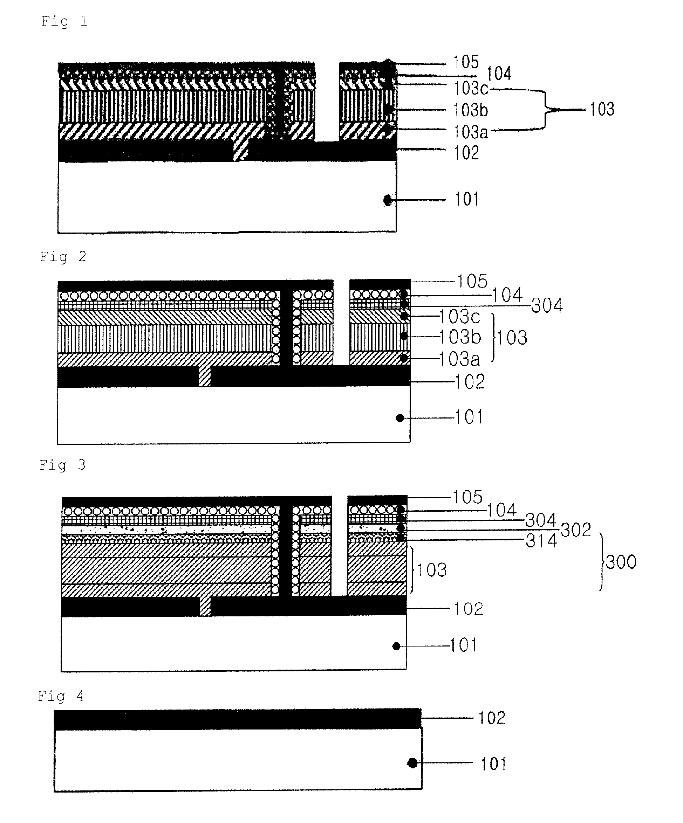

The thin-film type solar cell using amorphous silicon has a structure where a glass substrate 101, a lower transparent conductive layer (TCO) 102, an amorphous silicon solar cell layer (a-Si:H p/i/n layer) 103, a first transparent conductive layer (upper transparent conductive layer) 104, and a rear surface electrode layer 105 are stacked in sequence, as shown in FIG. 1.

### [Disclosure]

### Summary

An object of the present invention is to provide a thin-film type solar cell which has a silicon semiconductor layer formed of at least one amorphous silicon (p/i/n) thin film or a tandem type thin film formed of an amorphous silicon thin film and a microcrystalline silicon thin film, and which stacks another transparent metal oxide layer mixed with trace impurities between the silicon semiconductor layer and a transparent metal oxide layer to enable prevention of deterioration of device characteristics of the solar cell by pollutants that may occur when the solar cell is cut.

To achieve the above object, the present invention provides a thin-film type solar cell comprising another upper transparent conductive layer (a first upper transparent conductive layer) between a silicon semiconductor layer and an upper transparent conductive layer(a second upper transparent conductive layer).

Preferably, the silicon based semiconductor layer is formed of at least one amorphous silicon based (p/i/n) thin film, or an amorphous silicon based (p/i/n) thin film and a microcrystalline silicon based thin film.

Preferably, the thin-film type solar cell of the present invention further comprises an intermediate transparent conductive layer between the amorphous silicon based (p/i/n) thin film and the microcrystalline silicon based thin film.

Preferably, the upper transparent conductive layer, the another upper transparent conductive layer, and the intermediate transparent conductive layer are formed of metal oxide.

Preferably, the metal oxide is one or more oxide selected from a group consisting of stannum oxide (SnO₂), zinc oxide (ZnO) and ITO.

Preferably, the another upper transparent conductive layer is formed of the same substance as that of the upper transparent conductive layer.

Preferably, the another upper transparent conductive layer is mixed with one or more of impurities selected from a group consisting of aluminum (Al), fluorine (F), iron (Fe), gallium (Ga), and boron (B).

According to another aspect of the present invention, there is provided a manufacturing method of a solar cell comprising: depositing and patterning a lower transparent conductive layer on an upper surface of a glass substrate; depositing a silicon based semiconductor layer on the lower transparent conductive layer; depositing and patterning a first upper transparent conductive layer; and after depositing a second upper transparent conductive layer and a rear surface electrode layer in sequence on the first upper transparent conductive layer, patterning the rear surface electrode layer, the first and second upper transparent conductive layers, and the silicon based semiconductor layer.

Preferably, the step of depositing the silicon semiconductor layer comprises depositing at least one amorphous silicon based (p/i/n) thin film on the upper part of the patterned lower transparent conductive layer.

Preferably, the step of patterning the silicon based semiconductor layer comprises depositing the amorphous silicon based (p/i/n) thin film and a microcrystalline silicon based thin film on the upper part of the patterned lower transparent conductive layer.

Preferably, an intermediate transparent conductive layer is stacked between the amorphous silicon based (p/i/n) thin film and the microcrystalline silicon based thin film.

Preferably, the patterning is performed using a laser scribing method.

### [Description of Drawings]

The above and other objects, features and advantages of the present invention will become apparent from the following description of preferred embodiments given in conjunction with the accompanying drawings, in which:
FIG. 1 is a cross-sectional view of a conventional thin-film type solar cell; and
FIGS. 2 to 13 are cross-sectional views of a thin-film type solar cell and a manufacturing method thereof according to an embodiment of the present invention.

### [Detailed descryption]

The present invention may be embodied in diverse forms and may have diverse embodiments, and as such, the present invention will be described in detail with reference to the accompanying drawings for certain embodiments. However, the present invention should not be construed as limited to the embodiments set forth herein. Rather, it is intended that the present invention covers all modifications and variations of this invention provided they come within the scope of the appended claims and their equivalents.

FIGS. 2 and 3 are cross-sectional views of a thin-film type solar cell according to an embodiment of the present invention.

Referring to FIGS. 2 and 3, the thin-film type solar cell according to the present invention comprises a glass substrate 101, a lower transparent conductive layer 102, a silicon based semiconductor layer, a second transparent conductive layer (upper transparent conductive layer) 104, and a rear surface electrode layer 105, wherein a first transparent conductive layer 304 is provided between the silicon based semiconductor layer and the second transparent conductive layer as another upper transparent conductive layer.

The thin-film type solar cell as shown in FIG. 2 includes a silicon based semiconductor layer formed of an amorphous silicon based (p/i/n) thin film 103, and the thin-film solar cell as shown in FIG. 3 includes a tandem type silicon based semiconductor layer 300.

In the thin-film type solar cell, the glass substrate 101 is formed on the lowest part, the lower transparent conductive layer 102 that is the third transparent conductive layer is stacked on the upper surface of the glass substrate 101, and then the lower transparent conductive layer 102 is patterned.

A patterning method can be implemented conforming to a level of those skilled in the art, and a laser scribing method can be used in the present invention. However, the present invention is not limited thereto.

The silicon based semiconductor layer and a first transparent conductive layer 304 are stacked in sequence on the upper part of the patterned lower transparent conductive layer 102, wherein the silicon based semiconductor layer and the first transparent conductive layer 304 are also simultaneously patterned in a predetermined shape.

The silicon based semiconductor layer may be formed of an amorphous silicon based (p/i/n) thin film 103 (see FIG. 2.) or may be formed as a tandem type silicon based semiconductor layer 300 in which the amorphous silicon based (p/i/n) thin film 103 and a microcrystalline silicon based thin film 302 are stacked (see FIG. 3).

At this time, when the silicon based semiconductor layer is formed as the tandem type silicon based semiconductor 300, an intermediate transparent conductive layer 314 that is a fourth transparent conductive layer can be formed between the amorphous silicon based (p/i/n) thin film 103 and the microcrystalline silicon based thin film 302.

The intermediate transparent conductive layer 314 may be formed having the same composition as the metal oxide of the first transparent conductive layer 304.

And, as the patterning method of the silicon based semiconductor layer and the first transparent conductive layer 304, the laser scribing method is also used. A second transparent conductive layer 104 and a rear surface electrode layer 105 are stacked in sequence on the first transparent conductive layer 304, and the parts from the silicon based semiconductor layer to the rear surface electrode layer 105 are patterned again.

In this embodiment of the present invention, the silicon based semiconductor layer is shown as having one layer. However, a plurality of silicon based semiconductor layers may be stacked, wherein the first transparent conductive layer 304 and the second transparent conductive layer 104 may be formed of the same substance.

And, the first transparent conductive layer 304, the second transparent conductive layer 104, and the intermediate transparent conductive layer 314 may be formed of metal oxide such as stannum oxide (SnO₂), zinc oxide (ZnO), ITO and so on, and may be formed of a substance mixed with one or more impurities selected from a group consisting of fluorine (F), aluminum (Al), iron (Fe), gallium (Ga), and boron (B). Also, the rear surface electrode layer 105 may be manufactured with one metal selected from a group consisting of gold (Au), silver (Ag) or aluminum (Al).

FIGS. 4 to 13 are cross-sectional views showing a manufacturing process of a thin-film type solar cell according to an embodiment of the present invention.

FIGS. 4 to 13 depict a method of forming a silicon based semiconductor layer in a single layer using an amorphous silicon based (p/i/n) thin film 103, wherein a lower transparent conductive layer 102 is deposited and patterned on upper surface of a glass substrate 101 and then an amorphous silicon based (p/i/n) thin film 103 is deposited thereon.

At this time, the amorphous silicon based (p/i/n) thin film 103 is formed by stacking p-type 103a, i-type 103b, and n-type 103c thin films in sequence from the lower glass substrate direction, wherein a plurality of p/n/i junctions may be formed (FIGS. 4 to 8).

And, although not shown in the drawings, when a tandem type silicon based semiconductor layer is deposited instead of the amorphous silicon based (p/i/n) thin film 103, it may be formed by stacking the amorphous silicon based (p/i/n) thin film 103, an intermediate transparent electrode layer (not shown) and a microcrystalline silicon based thin film (not shown) in sequence.

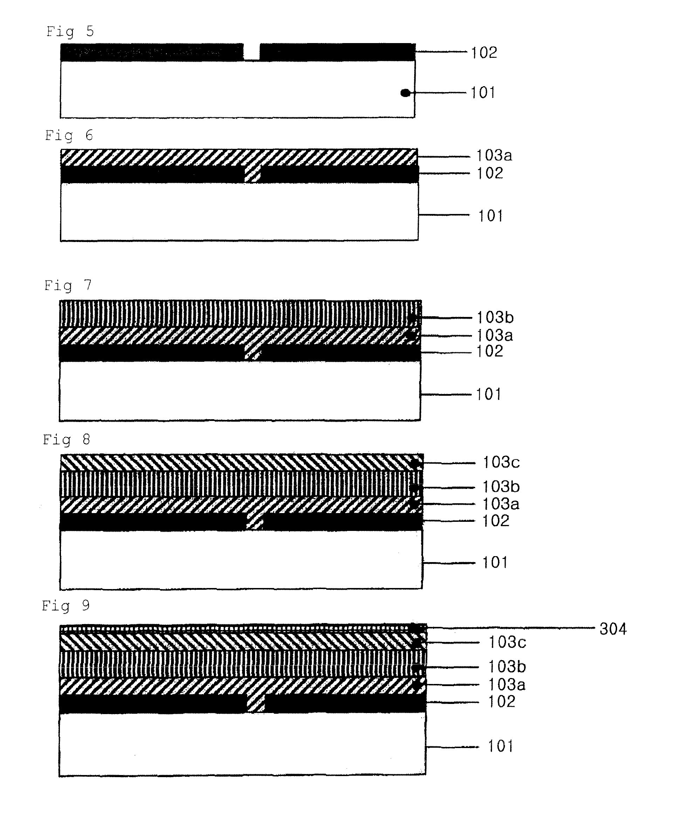

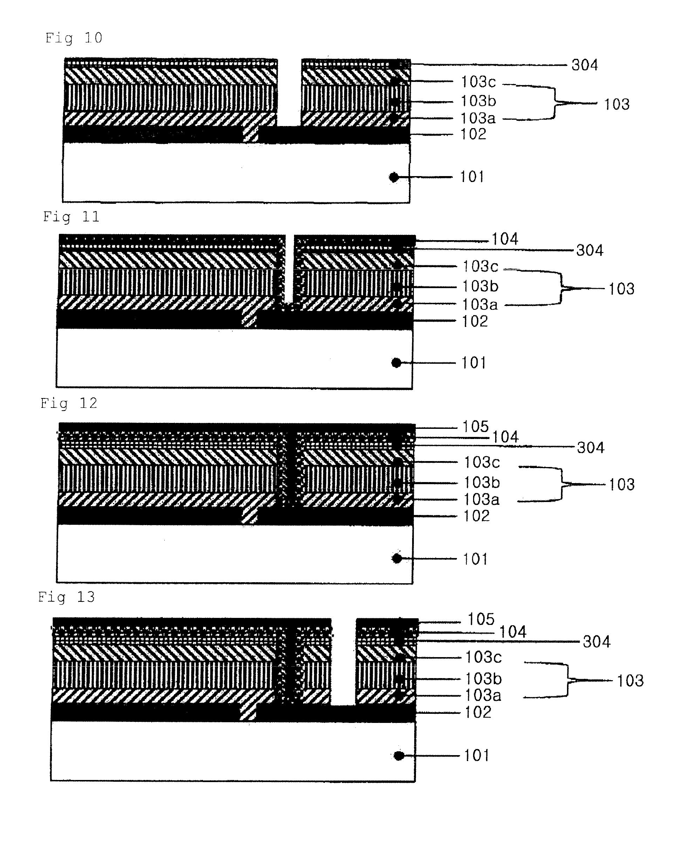

A first transparent conductive layer 304 is deposited on the upper part of the amorphous silicon based (p/i/n) thin film 103 (see FIG. 9) stacked as described above (see FIG. 8), and then the first transparent conductive layer 304 and the amorphous silicon based (p/i/n) thin film 103 are patterned simultaneously (FIG. 10). At this time, although a patterning method used is not limited, a laser scribing method may be used.

A second transparent conductive layer 104 is deposited on the upper part of the patterned first transparent conductive layer 304 (FIG. 11), and then a rear surface electrode layer 105 is formed (FIG. 12). Finally, in order to electrically insulate cells adjacent to each other, the amorphous silicon based (p/i/n) thin film 103 which is positioned at particular area, the first transparent conductive layer 304, the second transparent conductive layer 104, and the rear surface electrode layer 105 are removed through the laser scribing method (FIG. 13).

The thin-film type solar cell manufactured as describe above is formed having two layers formed of the first and second transparent conductive layers 304 and 104, wherein the first transparent conductive layer 304 can prevent the contamination and oxidization of the solar cell layer during the laser scribing process and the washing process, and the second transparent conductive layer 104 can prevent the loss of solar light by metal by preventing the rear surface electrode layer 105 mainly manufactured of metal from being directly connected to the solar cell layer.

The terms used in this application are for merely explaining a specific embodiment, not for limiting the present invention. A singular expression includes a plural expression, so far as it does not mean that they are clearly different from the context. In this application, terms "comprise" or "have" and so on are for designating that features, numbers, steps, operations, constituents, and components described in the specification, or the combination thereof are present, not for excluding the presence of one or more other features, numbers, steps, operations, constituents, and components described in the specification, or the combination thereof, or the additional possibility thereof.

So far as not being differently defined, all terms used herein including technical or scientific terminologies have meanings that they are commonly understood by those skilled in the art to which the present invention pertains. The terms having the definitions as defined in the dictionary should be understood such that they have meanings consistent with the context of the related technique. So far as not being clearly defined in this application, terms should not be understood in an ideally or excessively formal way.

Those skilled in the art will appreciate that various modifications and variations can be made in the present invention without departing from the spirit or scope of the inventions. Also, the substances of each constituent explained in the specification can be easily selected and processed by those skilled in the art from the well-known various substances. Also, those skilled in the art can remove a part of the constituents as described in the specification without deterioration of performance or can add constituents for improving the performance. Furthermore, those skilled in the art can change the order to methodic steps explained in the specification according to environments of processes or equipment. Thus, it is intended that the present invention covers the modifications and variations of this invention provided they come within the scope of the appended claims and their equivalents.

With the present invention as described above, the loss of light in the solar light can be reduced by simultaneously preventing the oxidation and contamination of the solar cell during the processing thereof and preventing the direct contact of the solar cell layer with the metal layer.

Therefore, the solar cell device having a high photoelectric conversion efficiency can be manufactured.

If the present invention is commercialized, the solar cell will contribute to environmental preservation of the earth as a next-generation clean energy source, and can be of enormous economic value by being applied directly to public facilities, private facilities, military facilities and so on.

## Claims

1. A thin-film type solar cell comprising:
another upper transparent conductive layer between a silicon based semiconductor layer and an upper transparent conductive layer.

2. The thin-film type solar cell according to claim 1, wherein the silicon based semiconductor layer is formed of at least one amorphous silicon based (p/i/n) thin film, or an amorphous silicon based (p/i/n) thin film and a microcrystalline silicon based thin film.

3. The thin-film type solar cell according to claim 2, further comprising an intermediate transparent conductive layer between the amorphous silicon based (p/i/n) thin film and the microcrystalline silicon based thin film.

4. The thin-film type solar cell according to claim 1, wherein the upper transparent conductive layer and the another upper transparent conductive layer are formed of metal oxide.

5. The thin-film type solar cell according to claim 3, wherein the intermediate transparent conductive layer is formed of metal oxide.

6. The thin-film type solar cell according to claim 4 or 5, wherein the metal oxide is one or more oxide selected from a group consisting of stannum oxide (SnO₂), zinc oxide (ZnO) and ITO.

7. The thin-film type solar cell according to claim 1, wherein the another upper transparent conductive layer is formed of the same substance as that of the upper transparent conductive layer.

8. The thin-film type solar cell according to claim 1, wherein the another upper transparent conductive layer is mixed with one or more of impurities selected from a group consisting of aluminum (Al), fluorine (F), iron (Fe), gallium (Ga), and boron (B).

9. A manufacturing method of a solar cell comprising:
depositing and patterning a lower transparent conductive layer on an upper surface of a glass substrate;
depositing a silicon based semiconductor layer on the lower transparent conductive layer;
depositing and patterning a first upper transparent conductive layer; and
after depositing a second upper transparent conductive layer and a rear surface electrode layer in sequence on the first upper transparent conductive layer, patterning the rear surface electrode layer, the first and second upper transparent conductive layers, and the silicon based semiconductor layer.

10. The manufacturing method of the solar cell according to claim 9, wherein the step of depositing the silicon based semiconductor layer comprises depositing at least one amorphous silicon based (p/i/n) thin film on the upper part of the patterned lower transparent conductive layer.

11. The manufacturing method of the solar cell according to claim 9, wherein the step of patterning the silicon based semiconductor layer comprises depositing the amorphous silicon based (p/i/n) thin film and a microcrystalline silicon based thin film on the upper part of the patterned lower transparent conductive layer.

12. The manufacturing method of the solar cell according to claim 11, wherein an intermediate transparent conductive layer is stacked between the amorphous silicon based (p/i/n) thin film and the microcrystalline silicon based thin film.

13. The manufacturing method of the solar cell according to claim 9, wherein the patterning is performed using a laser scribing method.
